# EUROPEAN PATENT APPLICATION

(11) **EP 4 614 560 A1**
(43) Date of publication of application: **10.09.2025**
(21) Application number: 23885573.8
(22) Date of filing: 23.10.2023
(51) Int. Cl.: H01L 23/29, H01L 23/12, H01L 23/31

(54) **COMPONENT MOUNTING BOARD, METHOD FOR MANUFACTURING COMPONENT MOUNTING BOARD, ELECTRONIC MODULE, AND METHOD FOR MANUFACTURING ELECTRONIC MODULE**

(30) Priority: 31.10.2022 JP 2022175152
(71) Applicant: NHK Spring Co., Ltd., Kanagawa 236-0004 (JP)
(72) Inventor: SUZUKI, Kohei, Yokohama-shi, Kanagawa 236-0004 (JP); YUKIMASA, Taro, Yokohama-shi, Kanagawa 236-0004 (JP); SHIMOMURA, Kohei, Yokohama-shi, Kanagawa 236-0004 (JP)
(74) Representative: DREISS Patentanwälte PartG mbB
(86) International application number: PCT/JP2023/038223
(87) International publication number: WO 2024/095813

(57) **Abstract**

There is provided an electronic module that can prevent the occurrence of creeping discharge and whose mass producibility is improved. An electronic module (30) has: a circuit board (12) in which a metal layer (16), which structures wiring patterns (18), and a metal base (13) are layered via an insulating layer (14); electronic components (20) joined to the wiring patterns (18); and a coating film (24) formed at obverses and side surfaces of the electronic components (20) and the circuit board (12) by ceramic coating or glass coating.

## Description

### Technical Field

The present disclosure relates to a components-mounting substrate, a components-mounting substrate manufacturing method, an electronic module, and an electronic module manufacturing method.

### Background Art

Japanese Patent Application Laid-Open (JP-A) No. 2021-34534 discloses a circuit board in which a circuit portion and a base substrate are layered via an insulating layer. Wiring patterns are formed by etching on the metal plate that structures the circuit portion, and a resin portion formed of a resin that is different than that of the insulating layer is provided in the gap between the wiring patterns and at the outer peripheral surface portions of the wiring patterns. Electronic components such as semiconductor elements for example are mounted on such a circuit board, and the electronic components and circuit board are sealed by a sealing resin. An electronic module is thereby manufactured.

### SUMMARY OF INVENTION

### Technical Problem

In recent years, accompanying the diversification of environments in which electronic equipment are used, an increase in the current capacity of circuit boards of electronic modules has been demanded. The current capacity of a circuit board can be increased by making the metal plate that structures the wiring patterns more thick. However, if the metal plate that structures the wiring patterns is made to be thicker, there are cases in which peeling of the sealing resin or the formation of air bubbles arises in the gap between the wiring patterns and at the outer peripheral surface portions of the wiring patterns. When voltage is applied to the circuit board in such a state, creeping discharge occurs at the gap between the wiring patterns and at the outer peripheral surface portions of the wiring patterns. Such creeping discharge is a cause of dielectric breakdown.

With regard to this point, in the above-described prior art, resin portions are provided at the gap between the wiring patterns and at the outer peripheral surface portions of the wiring patterns, and therefore, peeling of the sealing resin and the formation of air bubbles such as described above can be prevented. However, because the resin adheres to the obverses of the wiring patterns at the time of forming the above-described resin portions, a resin polishing step that removes the resin at the obverses of the wiring patterns is needed. In the resin polishing step, problems such as the buffing tool that is used in polishing becoming clogged occur, and therefore, the mass producibility is poor.

In view of the above-described circumstances, an object of the present disclosure is to provide a components-mounting substrate, a components-mounting substrate manufacturing method, an electronic module, and an electronic module manufacturing method that can prevent the occurrence of creeping discharge and whose mass producibility is improved.

### Solution to Problem

A components-mounting substrate of a first aspect has: a circuit board in which a conductor layer, which structures wiring patterns, and a base substrate are layered via an insulating layer; electronic components joined to the wiring patterns; and a coating film formed at obverses and side surfaces of the electronic components and the circuit board by ceramic coating or glass coating.

In accordance with the components-mounting substrate of the first aspect, at the circuit board, the conductor layer that structures the wiring patterns and the base substrate are layered via the insulating layer, and electronic components are joined to the wiring patterns. A coating film is formed by ceramic coating or glass coating on the obverses and the side surfaces of the electronic components and the circuit board. This coating film is interposed between, on the one hand, the sealing resin that seals the obverses and the side surfaces of the electronic components and the circuit board, and, on the other hand, the electronic components and the circuit board. Therefore, even if peeling of the sealing resin or the formation of air bubbles occurs in the gap between the wiring patterns or at the outer peripheral surface portions of the wiring patterns, the occurrence of creeping discharge can be prevented. Moreover, because a step of providing a resin portion in the gap between the wiring patterns or the like, and a resin polishing step of removing resin adhering to the obverses of the wiring patterns, are unnecessary, the mass producibility improves.

A components-mounting substrate manufacturing method of a second aspect has: a main body preparing step of preparing a mounting substrate main body having a circuit board in which a conductor layer, which structures wiring patterns, and a base substrate are layered via an insulating layer, and electronic components joined to the wiring patterns; and a coating step of carrying out ceramic coating or glass coating on obverses and side surfaces of the electronic components and the circuit board.

In accordance with the components-mounting substrate manufacturing method of the second aspect, a mounting substrate main body having a circuit board in which a conductor layer, which structures wiring patterns, and a base substrate are layered via an insulating layer, and electronic components joined to the wiring patterns, is prepared in in the main body preparing step. In the coating step, ceramic coating or glass coating is carried out on the obverses and the side surfaces of the electronic components and the circuit board. The coating film formed by this coating step is interposed between, on the one hand, the sealing resin that seals the obverses and side surfaces of the electronic components and the circuit board, and, on the other hand, the electronic components and the circuit board. Therefore, even if peeling of the sealing resin or the formation of air bubbles arises in the gap between the wiring patterns or at the outer peripheral surface portions of the wiring patterns, the occurrence of creeping discharge can be prevented. Moreover, because a step of providing a resin portion in the gap between the wiring patterns or the like, and a resin polishing step of removing resin adhering to the obverses of the wiring patterns, are unnecessary, the mass producibility improves.

An electronic module of a third aspect has: a circuit board in which a conductor layer, which structures wiring patterns, and a base substrate are layered via an insulating layer; electronic components joined to the wiring patterns; a sealing resin sealing obverses and side surfaces of the electronic components and the circuit board; and a coating film formed at the obverses and the side surfaces of the electronic components and the circuit board by ceramic coating or glass coating, and interposed between the circuit board and the electronic components on the one hand and the sealing resin on the other hand.

In accordance with the electronic module of the third aspect, at the circuit board, the conductor layer that structures the wiring patterns and the base substrate are layered via the insulating layer, and electronic components are joined to the wiring patterns. The obverses and the side surfaces of the electronic components and the circuit board are sealed by a sealing resin. A coating film, which is formed by ceramic coating or glass coating on the obverses and the side surfaces of the electronic components and the circuit board, is interposed between the circuit board and the electronic components on the one hand and the sealing resin on the other hand. Therefore, even if peeling of the sealing resin or the formation of air bubbles arises in the gap between the wiring patterns or at the outer peripheral surface portions of the wiring patterns, the occurrence of creeping discharge can be prevented. Moreover, because a step of providing a resin portion in the gap between the wiring patterns or the like, and a resin polishing step of removing resin adhering to the obverses of the wiring patterns, are unnecessary, the mass producibility improves.

An electronic module manufacturing method of a fourth aspect has: a substrate preparing step of preparing a components-mounting substrate having a circuit board in which a conductor layer, which structures wiring patterns, and a base substrate are layered via an insulating layer, and electronic components joined to the wiring patterns, and at which ceramic coating or glass coating is carried out on obverses and side surfaces of the electronic components and the circuit board; and a sealing step of sealing the obverses and the side surfaces of the electronic components and the circuit board by a sealing resin.

In accordance with the fourth aspect, in the substrate preparing step, there is prepared a components-mounting substrate having a circuit board in which a conductor layer, which structures wiring patterns, and a base substrate are layered via an insulating layer, and electronic components joined to the wiring patterns, and at which ceramic coating or glass coating is carried out on the obverses and the side surfaces of the electronic components and the circuit board. In the sealing step, the obverses and the side surfaces of the electronic components and the circuit board are sealed by a sealing resin. The above-described coating film is interposed between the sealing resin on the one hand and the electronic components and the circuit board on the other hand. Therefore, even if peeling of the sealing resin or the formation of air bubbles arises in the gap between the wiring patterns or at the outer peripheral surface portions of the wiring patterns, the occurrence of creeping discharge can be prevented. Moreover, because a step of providing a resin portion in the gap between the wiring patterns or the like, and a resin polishing step of removing resin adhering to the obverses of the wiring patterns, are unnecessary, the mass producibility improves.

### Advantageous Effects of Invention

As described above, in the components-mounting substrate, components-mounting substrate manufacturing method, electronic module and electronic module manufacturing method relating to the present disclosure, the occurrence of creeping discharge can be prevented and mass producibility is improved.

### BRIEF DESCRIPTION OF DRAWINGS

Fig. 1 is a cross-sectional view illustrating a mounting substrate main body of a components-mounting substrate relating to an embodiment.
Fig. 2 is a cross-sectional view illustrating the components-mounting substrate relating to the embodiment.
Fig. 3 is a cross-sectional view illustrating an electronic module relating to the embodiment.
Fig. 4 is a cross-sectional view illustrating an electronic module relating to a first comparative example.
Fig. 5 is a cross-sectional view illustrating an electronic module relating to a second comparative example.

### DESCRIPTION OF EMBODIMENTS

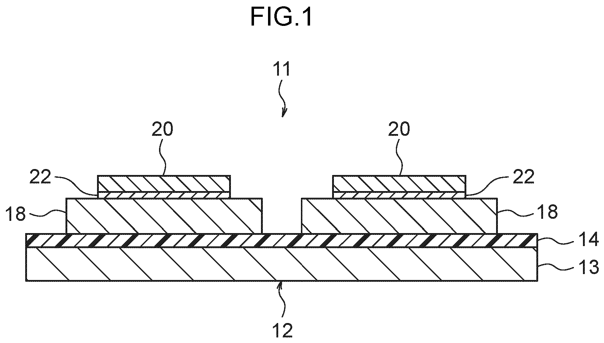

A components-mounting substrate 10 and an electronic module 30 relating to an embodiment of the present disclosure are described hereinafter with reference to Fig. 1 through

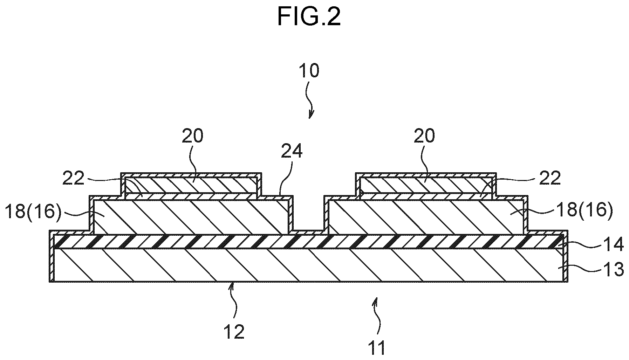

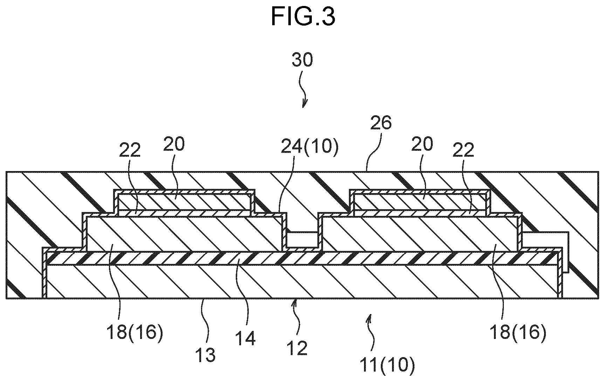

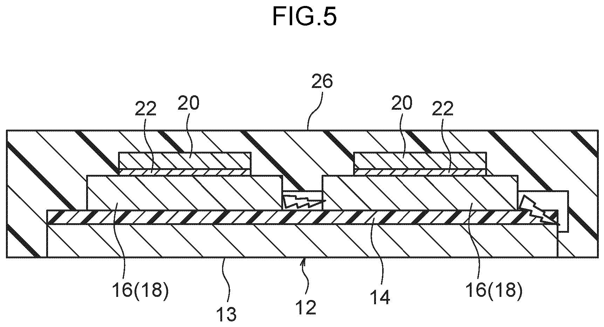

Fig. 5. As illustrated in Fig. 3, the electronic module 30 relating to the present embodiment is structured by the components-mounting substrate 10 and a sealing resin 26. As illustrated in Fig. 2, the components-mounting substrate 10 is structured by a circuit board 12, electronic components 20 that are heat generating bodies, and a coating film 24.

As illustrated in Fig. 1 through Fig. 3, the circuit board 12 has a metal base 13, an insulating layer 14 layered on the metal base 13, and a metal layer 16 layered on the insulating layer 14 at the side opposite the metal base 13 and structuring wiring patterns (circuit patterns) 18. The metal base 13 corresponds to the "base substrate" in the present disclosure, and the metal layer 16 corresponds to the "conductor layer" in the present disclosure.

The metal base 13 is a substrate structured by a metal material. Materials having high thermal conductivity such as copper, copper alloys, aluminum and aluminum alloys for example are used as the material of the metal plate that structures the metal base 13. The thickness of the metal base 13 is set to be in the range of 1.0 mm to 3.0 mm for example. Note that there are cases in which an unillustrated heat dissipating means such as heat dissipating fins or a radiator is mounted to the surface of the metal base 13 which surface is at the side opposite the insulating layer 14.

The insulating layer 14 is a layer in which, for example, a filler that is insulating and thermally conductive is mixed into a synthetic resin that is electrically insulating. A synthetic resin that has good electrical insulating ability and thermal conductivity, such as an epoxy resin that is a thermosetting synthetic resin having an epoxy group, for example is used as the aforementioned synthetic resin. A filler that is chemically stable and has good thermal conductivity and electrical insulating ability such as silicon dioxide (silica), aluminum oxide (alumina), aluminum nitride or boron nitride for example is used as the aforementioned filler. The thickness of the insulating layer 14 is set to be in the range of 0.06 mm to 0.2 mm for example. Note that the insulating layer 14 may be a structure in which, instead of a filler that is thermally conductive, glass fibers are mixed into a synthetic resin that is electrically insulating.

The metal layer 16 is structured by a metal material that is electrically conductive for example. For example, a rolled copper plate or an aluminum plate is used as the metal material structuring the metal layer 16. The thickness of the metal layer 16 is set to be in the range of 0.3 mm to 1.5 mm for example. This metal layer 16 is a structure at which etching is carried out on a metal layer that is layered at the side of the insulating layer 14 opposite the metal base 13, and the metal layer 16 structures the predetermined wiring patterns 18. Metal plating (not illustrated) is carried out on the obverses of the wiring patterns 18. The thickness of the metal plating is set to be in the range of 0.1 µm to 0.4 µm for example. Note that the metal layer 16 may be a structure in which punching by a die press is carried out on a lead frame material for example. However, in the case of die pressing, it is easy for burrs and the like to form, and therefore, a step for removing the aforementioned burrs is needed before layering the metal layer 16 on the insulating layer 14.

The electronic components 20 are joined to the obverses of the wiring patterns 18 by using solder 22 that is an example of an electrically-conductive joining material. A mounting substrate main body 11 is thereby structured. Examples of these electronic components 20 are semiconductor chips, transistors, diodes, light-emitting diodes, thyristors, capacitors, resistors, resistor arrays, coils and switches.

The coating film 24 is a thin film that is formed on the obverses and the side surfaces of the electronic components 20 and the circuit board 12 by ceramic coating. The sol-gel method is an example of the method of forming the coating film 24. The main components of the ceramic coating are, for example, a ceramic powder such as silica, alumina, zirconia or silicon carbide, an inorganic binder, and water that is the solvent. The film thickness of this coating film 24 is set to be in the range of 1 µm to 10 µm for example. Due to this coating film 24 being formed, the components-mounting substrate 10 illustrated in Fig. 2 is completed.

Because the heat resistance of ceramic coatings is high, ceramic coatings do not deteriorate in the range of usage temperatures of general power modules (200°C or less). In the sol-gel method, processing can be carried out by immersing and extracting the target object into and from a sol liquid whose viscosity is low, and therefore, processes after the mounting of the electronic components 20 to the mounting substrate main body 11 are possible. Note that a glass coating may be employed instead of a ceramic coating.

In the electronic module 30 that includes the above-described components-mounting substrate 10, the obverses and the side surfaces of the electronic components 20 and the circuit board 12 are sealed by the sealing resin 26 as illustrated in Fig. 3. This sealing resin 26 is molded by transfer molding for example.

A manufacturing method for manufacturing the components-mounting substrate 10 and the electronic module 30 that have the above-described structures is described next. At the time of manufacturing the components-mounting substrate 10, first, a layered body, in which the metal base 13, the insulating layer 14 and the metal layer 16 are layered, is prepared, and the wiring patterns 18 are formed by carrying out etching on the metal layer 16.

A known method can be used as the method of manufacturing the above-described layered body. A liquid material (varnish material) serving as the material of the insulating layer 14 can be coated on at least one of the metal base 13 and the metal layer 16 by, for example, roll coating, bar coating or screen printing. Thereafter, the liquid material that is on the metal base 13 or on the metal layer 16 is dried by natural drying or forced drying. The insulating layer 14 is thereby obtained. The insulating layer 14 at this time may be in a state of not being cured completely (a so-called B-stage state). Next, the metal layer 16 is formed on the obverse of the insulating layer 14. Specifically, the metal layer 16 (e.g., a rolled copper plate) that is to become the wiring patterns 18 is layered by hot pressing or the like on the obverse of the insulating layer 14. The layered body, in which the metal layer 16 that structures the wiring patterns 18 and the metal base 13 are layered via the insulating layer 14, is thereby obtained.

In the etching step that is next, the metal layer 16 of the layered body that is obtained as described above is etched, and the predetermined wiring patterns 18 are formed. At the layered body after the etching step, inspection as to the absence/presence of defects is carried out in an automatic optical inspection step that is next. In the plating step that is next, without polishing the obverses of the wiring patterns 18 after the complete curing step, metal plating (not illustrated) is carried out on these obverses.

In the components-mounting step that is next, the electronic components 20 are joined to the obverses of the wiring patterns 18 by using the solder 22. The mounting substrate main body 11 is thereby completed. In the coating step that is next, a ceramic coating is carried out by the sol-gel method for example on the obverses and the side surfaces of the electronic components 20 and the circuit board 12. The components-mounting substrate 10 is thereby completed. In the sealing step that is next, the sealing resin 26 is molded by transfer molding for example. The electronic module 30 is thereby completed.

In the electronic module 30 of the above-described structure, at the circuit board 12, the metal layer 16 that structures the wiring patterns 18 and the metal base 13 are layered via the insulating layer 14, and the electronic components 20 are joined to the wiring patterns 18. The obverses and the side surfaces of the electronic components 20 and the circuit board 12 are sealed by the sealing resin 26. The coating film 24, which is formed at the obverses and the side surfaces of the electronic components 20 and the circuit board 12 by ceramic coating, is interposed between the circuit board 12 and the electronic components 20 on the one hand, and the sealing resin 26 on the other hand. Therefore, as illustrated in Fig. 3, even if peeling of the sealing resin or the formation of air bubbles occurs in the gap between the wiring patterns 18 or at the outer peripheral surface portions of the wiring patterns 18, the occurrence of creeping discharge can be prevented.

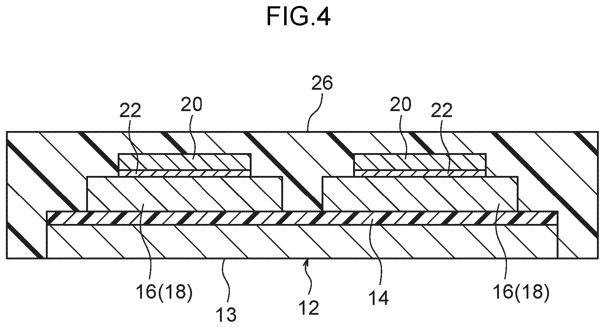

Supplemental description of the above-described effects is given by using Fig. 4 and Fig. 5. As in a first comparative example that is illustrated in Fig. 4, creeping discharge does not arise in a case in which peeling of the sealing resin or formation of air bubbles does not occur in the gap between the wiring patterns 18 or at the outer peripheral surface portions of the wiring patterns 18. However, if the metal layer 16 that structures the wiring patterns 18 is made to be thick, as in a second comparative example that is illustrated in Fig. 5, there are cases in which peeling of the sealing resin or formation of air bubbles arises in the gap between the wiring patterns 18 or at the outer peripheral surface portions of the wiring patterns 18. When voltage is applied to the electronic module 30 in such a state, creeping discharge arises in the gap between the wiring patterns 18 or at the outer peripheral surface portions of the wiring patterns 18. This creeping discharge is a cause of destruction of the insulating layer 14, but this can be avoided in the present embodiment.

Moreover, in the present embodiment, a step of providing a resin portion in the gap between the wiring patterns 18 or the like, and a resin polishing step of removing resin adhering to the obverses of the wiring patterns 18, are unnecessary, and therefore, the mass producibility improves. In particular, because a ceramic buffing tool that polishes the obverses of the wiring patterns becomes clogged in a resin polishing step, the mass producibility is poor. However, this can be avoided in the present embodiment.

Although the present disclosure has been described above by way of illustration of an embodiment, the present disclosure can be implemented by being modified in various ways within a scope that does not depart from the gist thereof. Further, the scope of the right of the present disclosure is, of course, not limited to the above-described embodiment.

The disclosure of Japanese Patent Application No. 2022-175152 filed on October 31, 2022 is, in its entirety, incorporated by reference into the present specification. All publications, patent applications, and technical standards mentioned in the present specification are incorporated by reference into the present specification to the same extent as if such individual publication, patent application, or technical standard was specifically and individually indicated to be incorporated by reference.

## Claims

1. A components-mounting substrate, comprising:
a circuit board in which a conductor layer, which structures wiring patterns, and a base substrate are layered via an insulating layer;
electronic components joined to the wiring patterns; and
a coating film formed at obverses and side surfaces of the electronic components and the circuit board by ceramic coating or glass coating.

2. A components-mounting substrate manufacturing method, comprising:
a main body preparing step of preparing a mounting substrate main body having a circuit board in which a conductor layer, which structures wiring patterns, and a base substrate are layered via an insulating layer, and electronic components joined to the wiring patterns; and
a coating step of carrying out ceramic coating or glass coating on obverses and side surfaces of the electronic components and the circuit board.

3. An electronic module, comprising:
a circuit board in which a conductor layer, which structures wiring patterns, and a base substrate are layered via an insulating layer;
electronic components joined to the wiring patterns;
a sealing resin sealing obverses and side surfaces of the electronic components and the circuit board; and
a coating film formed at the obverses and the side surfaces of the electronic components and the circuit board by ceramic coating or glass coating, and interposed between the circuit board and the electronic components on the one hand and the sealing resin on the other hand.

4. An electronic module manufacturing method, comprising:
a substrate preparing step of preparing a components-mounting substrate having a circuit board in which a conductor layer, which structures wiring patterns, and a base substrate are layered via an insulating layer, and electronic components joined to the wiring patterns, and at which ceramic coating or glass coating is carried out on obverses and side surfaces of the electronic components and the circuit board; and
a sealing step of sealing the obverses and the side surfaces of the electronic components and the circuit board by a sealing resin.
